# EUROPEAN PATENT APPLICATION

(11) **EP 4 571 827 A1**
(43) Date of publication of application: **18.06.2025**
(21) Application number: 24215548.9
(22) Date of filing: 26.11.2024
(51) Int. Cl.: H01L 23/13, H01L 23/498, H01L 23/538, H01L 23/00

(54) **SEMICONDUCTOR DEVICE HAVING EMBEDDED DIE AND METHOD THEREFOR**

(30) Priority: 27.11.2023 US 202318519268
(71) Applicant: NXP B.V., 5656 AG Eindhoven (NL)
(72) Inventor: MAO, Kuan-Hsiang, 5656AG Eindhoven (NL); CHUANG, Wen Yuan, 5656AG Eindhoven (NL); HIEW, Pey Fang, 5656AG Eindhoven (NL); HUANG, Wen Hung, 5656AG Eindhoven (NL); TIEN, Yujen, 5656AG Eindhoven (NL)
(74) Representative: Hardingham, Christopher Mark

(57) **Abstract**

A method of forming a semiconductor device with an embedded die is provided. The method includes forming a plurality of redistribution traces at a first major side of a package substrate. A cavity is formed in the package substrate. The plurality of redistribution traces substantially surrounding an opening of the cavity at the first major side. A semiconductor die is mounted in the cavity. A wire bond is formed between a bond pad of the semiconductor die and a wiring pad of a redistribution trace of the plurality of redistribution traces. An encapsulant encapsulates the semiconductor die and the first major side of the package substrate. A base region of the redistribution trace is exposed.

## Description

### Background

### Field

This disclosure relates generally to semiconductor device packaging, and more specifically, to a semiconductor device having an embedded die and method of forming the same.

### Related Art

Today, there is an increasing trend to include sophisticated semiconductor devices in products and systems that are used every day. These sophisticated semiconductor devices may include features for specific applications which may impact the configuration of the semiconductor device packages, for example. With such features and applications, the configuration of the semiconductor device packages may limit performance of the semiconductor devices or impact the costs of the semiconductor devices. Accordingly, significant challenges exist in accommodating these features and applications while minimizing the impact on semiconductor devices' performance and costs.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.
FIG. 1 illustrates, in a simplified bottom-side-up plan view, an example semiconductor device having an embedded semiconductor die at a stage of manufacture in accordance with an embodiment.
FIG. 2 through FIG. 7 illustrate, in simplified cross-sectional views, the example semiconductor device taken along line A-A of FIG. 1 at various stages of manufacture in accordance with an embodiment.

### Detailed Description

Generally, there is provided, a semiconductor device having an embedded die. The semiconductor device includes a package substrate with a cavity sized sufficiently to embed a semiconductor die within the cavity. The package substrate includes fiberglass reinforced epoxy resin core material such as FR4 with metal layers formed on both top and bottom side of the core. For example, a first metal layer (e.g., copper foil) is formed at a first major side (e.g., top) of the package substrate and a second metal layer (e.g., copper foil) is formed at a second major side (e.g., bottom) of the package substrate such the core is sandwiched between the first metal layer and the second metal layer. A plurality of redistribution traces is formed by patterning and etching the second metal layer, for example. The cavity is formed in central region of the package substrate. The cavity has an opening at the second major side and extends through the core and ends at an inner surface of a portion of the first metal layer at the first major side. The plurality of redistribution traces is arranged to substantially surround the cavity in a fanout configuration, for example. The semiconductor die is mounted in the cavity such that a backside of the semiconductor die is affixed to the exposed inner surface portion of the first metal layer. Bond pads at the active side of the semiconductor die are interconnected with respective redistribution traces by way of bond wires. An encapsulant encapsulates the semiconductor die and the second major side of the package substrate. Openings through the encapsulant are formed exposing base portions of the redistribution traces. Under-bump metallization structures are formed on respective exposed base portions of respective redistribution traces. Conductive package connectors (e.g., solder balls) are affixed to exposed surface portions of respective under-bump metallization structures. By forming the semiconductor device with an embedded semiconductor die in this manner, the semiconductor die is fully protected and capable of high-power applications requiring high current interconnects.

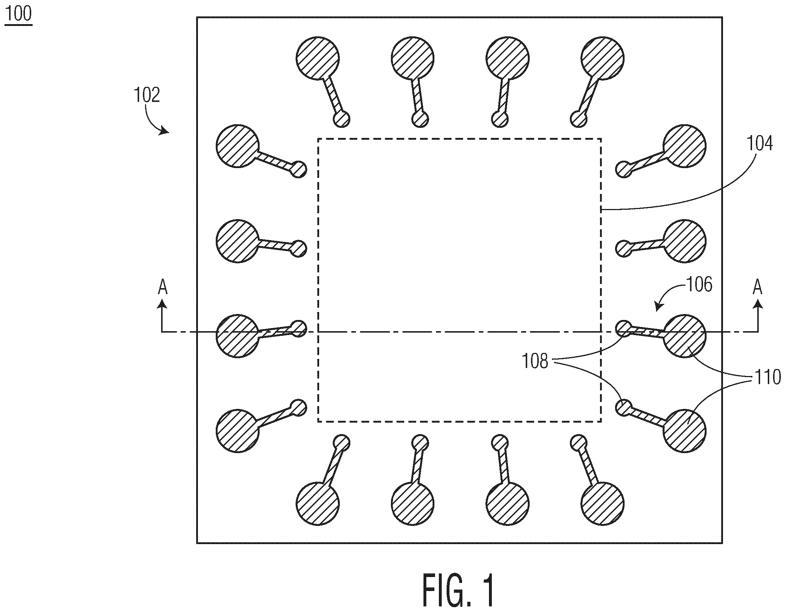

FIG. 1 illustrates, in a simplified bottom-side-up plan view, an example semiconductor device 100 having an embedded die in accordance with an embodiment. At this stage, the semiconductor device 100 includes a package substrate 102 and a plurality of metal redistribution traces 106 formed on the package substrate. The package substrate 102 has a bottom side (shown) and a top side (not shown). The package substrate 102 is formed from a non-conductive, fiberglass reinforced epoxy resin core material (e.g., FR4). In this embodiment, the package substrate 102 may be characterized as a metal clad FR4 substrate having a first metal layer at the top side and a second metal layer at the bottom side. The first metal layer and the second metal layer may be formed from suitable electrically conductive metal materials, such as copper, silver, nickel, aluminum, iron, or alloys thereof, for example. The redistribution traces 106 are formed at the bottom side of the package substrate. In this embodiment, the redistribution traces 106 are formed by way of patterning and etching the second metal layer at the bottom side of the package substrate 102. In some embodiments, the redistribution traces 106 may be formed by way of selective plating metal features at the bottom side of the package substrate 102 (which does not natively include the second metal layer).

An outline of a cavity formed in the package substrate 102 at a subsequent stage of manufacture is shown as a dashed line 104 for reference. The redistribution traces 106 are arranged to substantially surround the cavity and a semiconductor die mounted in the cavity at a subsequent stage of manufacture, for example. In this embodiment, each of the redistribution traces 106 includes a wiring pad region 108 (e.g., proximal end) and a base region 110 (e.g., distal end). The wiring pad region 108 is configured for conductive connection to the semiconductor die by way of a bond wire at a subsequent stage of manufacture, for example. In addition, the base region 110 is configured as a base for formation of an under-bump metallization (UBM) structure at a subsequent stage of manufacture, for example.

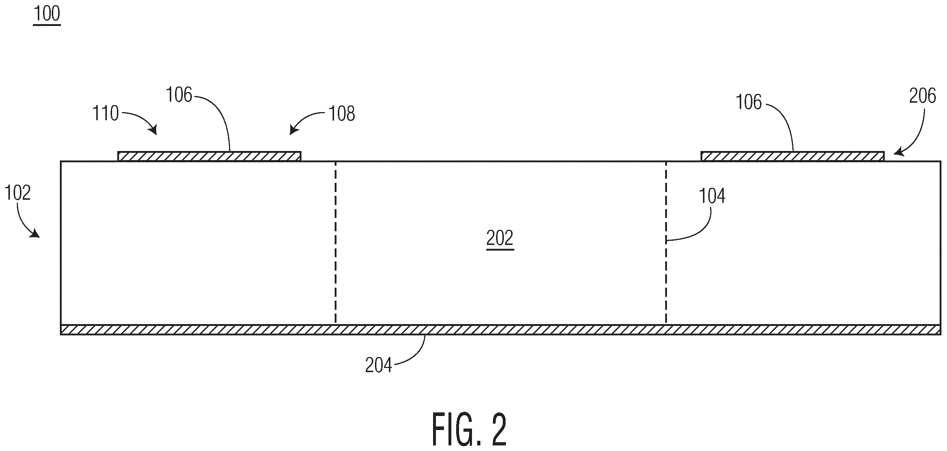

The shape, location, and number of the redistribution traces 106 of the package substrate 102 depicted in FIG. 1 are chosen for illustration purposes. The term "conductive," as used herein, generally refers to electrical conductivity unless otherwise described. Cross-sectional views of the example semiconductor device 100 having an embedded die taken along line A-A of FIG. 1 at various stages of manufacture are depicted in FIG. 2 through FIG. 7.

FIG. 2 illustrates, in a simplified bottom-side-up cross-sectional view, the example semiconductor device 100 at the stage of manufacture depicted in FIG. 1 in accordance with an embodiment. At this stage, the semiconductor device 100 includes the package substrate 102 and the plurality of redistribution traces 106 formed at the bottom side of the package substrate. The package substrate 102 includes the fiberglass reinforced epoxy resin core 202, the first metal layer 204 at the top side and the second metal layer 206 at the bottom side. In this embodiment, the package substrate 102 may be characterized as a metal (e.g., copper) clad FR4 substrate. In this embodiment, the redistribution traces 106 are formed by way of patterning and etching the second metal layer 206 at the bottom side of the package substrate 102.

An outline of a cavity formed in the package substrate 102 at a subsequent stage of manufacture is shown as a dashed line 104 for reference. In this embodiment, each of the redistribution traces 106 includes the wiring pad region 108 at a proximal end and a base region 110 at a distal end of the redistribution trace. For example, the wiring pad region 108 is configured for connection to the semiconductor die by way of a bond wire and the base region 110 is configured as a base for formation of a UBM structure at subsequent stages of manufacture, for example.

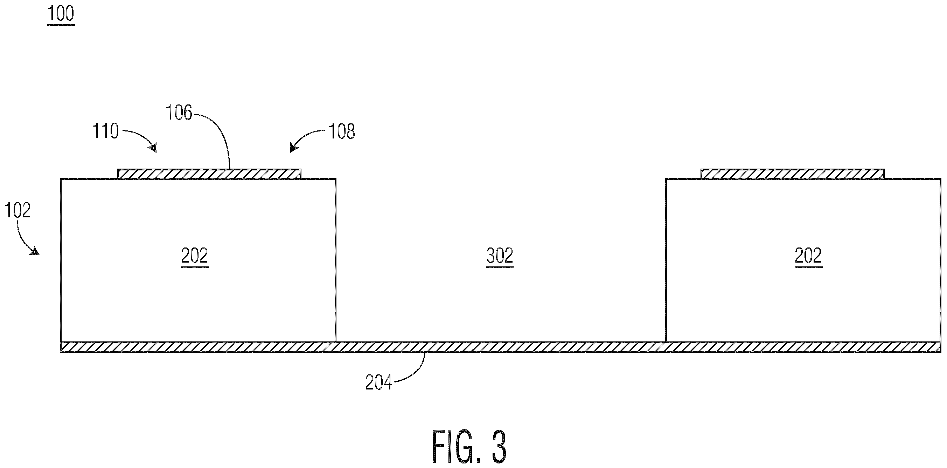

FIG. 3 illustrates, in a simplified bottom-side-up cross-sectional view, the example semiconductor device 100 at a subsequent stage of manufacture in accordance with an embodiment. At this stage, the semiconductor device 100 includes a cavity 302 formed in the package substrate 102. The cavity 302 includes an opening at the bottom side of the package substrate 302. In this embodiment, the cavity 302 is formed by way of laser ablation and extends from the opening at the bottom side, through the fiberglass reinforced epoxy resin core 202, and ends at the first metal layer 204 at the top side of the package substrate 102. As a result, an inner surface of a portion of the metal layer 204 is exposed through the cavity 302. In some embodiments, the cavity 302 may be formed such that a portion of the fiberglass reinforced epoxy resin core 202 remains between a bottom of the cavity 302 and the first metal layer 204 at the top side of the package substrate 102.

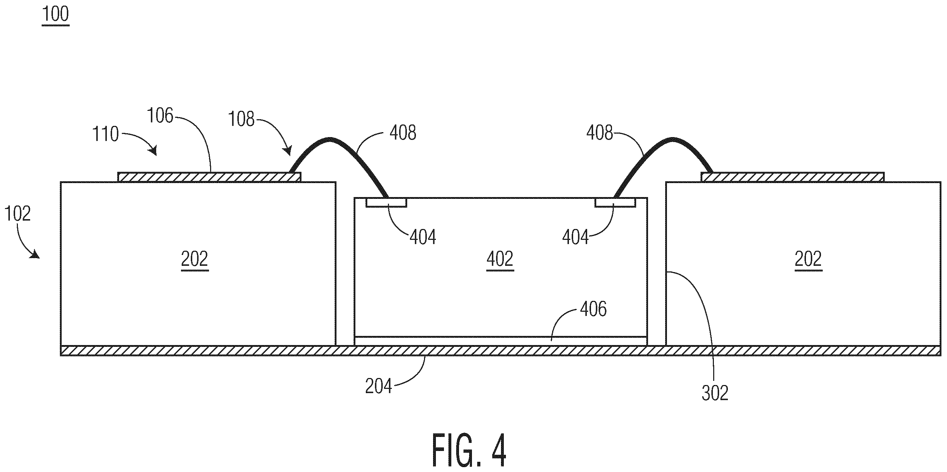

FIG. 4 illustrates, in a simplified bottom-side-up cross-sectional view, the example semiconductor device 100 at a subsequent stage of manufacture in accordance with an embodiment. At this stage, the semiconductor device 100 includes a semiconductor die 402 mounted in the cavity 302 and interconnected to respective redistribution traces 106. In this embodiment, a backside of the semiconductor die 402 is affixed to the exposed inner surface of the portion of the metal layer 204 by way of a die attach film (DAF) 406. It may be desirable for the DAF 406 to include suitable thermal conduction properties to accommodate high power applications, for example. In some embodiments, the semiconductor die 402 may be affixed to the portion of the metal layer 204 by way of other die attach adhesives, pastes, and the like.

The semiconductor die 402 has an active side (e.g., major side having circuitry, bond pads) and a backside (e.g., major side opposite of the active side). As depicted in the cross-sectional view of FIG. 4, the active side of the semiconductor die 402 is exposed at the opening of the cavity 302, for example. The semiconductor die 402 includes bond pads 404 located at the active side of the semiconductor die. The bond pads 404 are configured for connection to respective redistribution traces 106. The semiconductor die 402 may be formed from any suitable semiconductor material, such as silicon, germanium, gallium arsenide, gallium nitride, and the like. The semiconductor die 402 may further include digital circuits, analog circuits, RF circuits, power circuits, memory, processor, sensor, the like, and combinations thereof at the active side.

In this embodiment, bond pads 404 of the semiconductor die 402 interconnected with respective redistribution traces 106 by way of bond wires 408. In this embodiment, a first end of a first bond wire 408 is attached to a first bond pad 404 by way of a first bond (e.g., ball bond) and a second end of the first bond wire 408 is attached to a wiring pad region 108 of a respective redistribution trace 108 by way of a second bond (e.g., stitch bond).

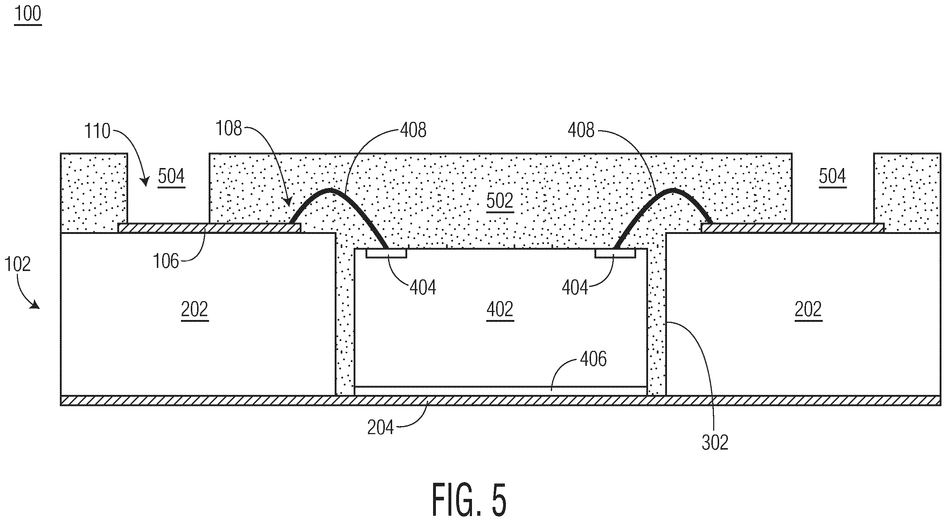

FIG. 5 illustrates, in a simplified bottom-side-up cross-sectional view, the example semiconductor device 100 at a subsequent stage of manufacture in accordance with an embodiment. At this stage, the semiconductor device 100 includes at least the semiconductor die 402 and the bottom side of the package substrate 102 encapsulated with an encapsulant 502. In this embodiment, the semiconductor die 402 and the bottom side of the package substrate 102 are over-molded with the encapsulant (e.g., epoxy molding compound) 502 by way of an injection molding or transfer molding process, for example.

After encapsulating the semiconductor die 402 and the bottom side of the package substrate 102, a plurality of cavities 504 are formed over the base regions 110 of respective redistribution traces 106. The cavities 504 include openings at the bottom side of the encapsulant 502 located directly over the base regions 110. In this embodiment, the cavities 504 are formed by way of laser ablation. Each of the cavities 504 extends from the opening at the bottom side, through the encapsulant 502, and ends at the metal base region 110 of a respective redistribution trace 106. As a result, at least a portion of the base region 110 of respective redistribution traces 106 is exposed through the cavities 504.

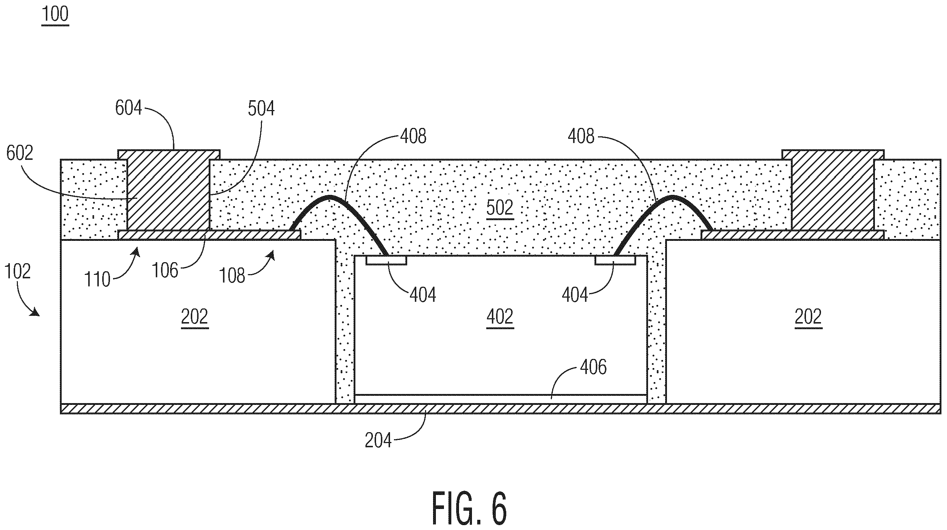

FIG. 6 illustrates, in a simplified bottom-side-up cross-sectional view, the example semiconductor device 100 at a subsequent stage of manufacture in accordance with an embodiment. At this stage, the semiconductor device 100 includes a plurality of UBM structures 602 formed on the exposed portion of the base region 110 of respective redistribution traces 106. In this embodiment, the UBM structures 602 may be formed by way of electroplating a metal material (e.g., copper), for example. Each of the plated UBM structures 602 substantially fills the respective cavities 504 formed over the base regions 110. A surface portion 604 of each UBM structure 602 is exposed at the bottom side of the encapsulant 502. In this embodiment, a conductive connection is formed between the each UBM structure 602 and the base region 110 of a respective redistribution trace 106.

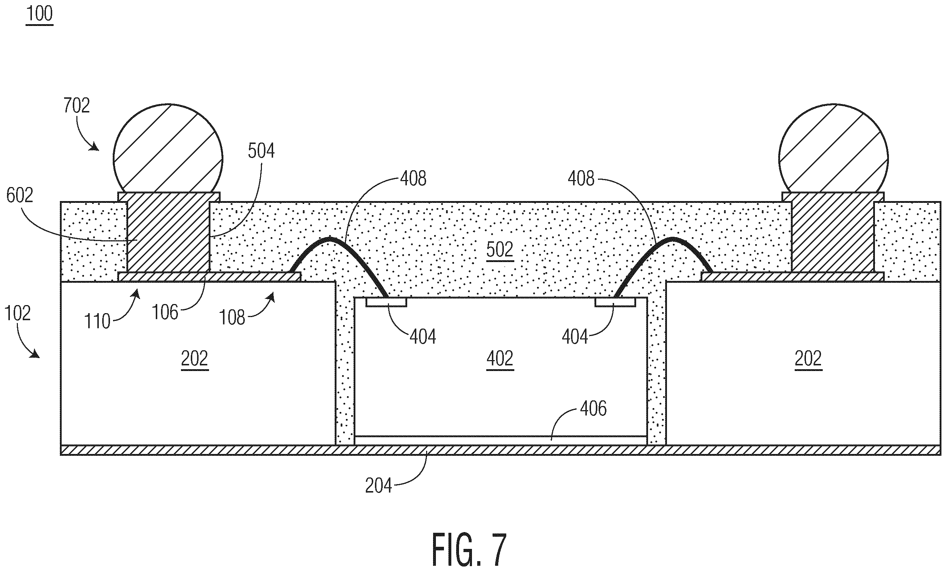

FIG. 7 illustrates, in a simplified bottom-side-up cross-sectional view, the example semiconductor device 100 at a subsequent stage of manufacture in accordance with an embodiment. At this stage, the semiconductor device 100 includes a plurality of conductive package connectors 702 affixed at the bottom side of the encapsulated semiconductor die 402 and the bottom side of the package substrate 102. In this embodiment, each of the conductive package connectors 702 are affixed to an exposed surface portion 604 of a respective UBM structure 602.The conductive connectors 702 are configured to provide a conductive connection between the embedded semiconductor die 402 and a printed circuit board, for example. The conductive connectors 702 may be formed in various suitable conductive connector structures such as solder balls, gold studs, copper pillars, and the like. For illustration purposes, the conductive connectors 802 are formed as ball connectors and arranged in a fanout configuration.

Generally, there is provided, a method including patterning a first metal layer at a first major side of a package substrate to form a plurality of redistribution traces; forming a first cavity in the package substrate, the plurality of redistribution traces substantially surrounding the first cavity; mounting a semiconductor die in the first cavity; forming a wire bond between a bond pad of the semiconductor die and a wiring pad region of a redistribution trace of the plurality of redistribution traces; encapsulating with an encapsulant the semiconductor die and the first major side of the package substrate; exposing a base region of the redistribution trace; and selectively plating an under-bump metallization (UBM) structure on the exposed base region. The exposing the base region of the redistribution trace may include forming a second cavity in the encapsulant by way of laser ablation, the base region of the redistribution trace exposed at the bottom of the second cavity. The selectively plating the UBM structure may include filling the second cavity with a copper or copper alloy material. The method may further include affixing a conductive package connector on the UBM structure. The forming the first cavity may include exposing a portion of a second metal layer at a second major side of the package substrate. The forming the first cavity in the package substrate may include using laser ablation to form the first cavity and expose the portion of the second metal layer. The mounting the semiconductor die in the first cavity may include affixing a backside of the semiconductor die to the exposed second metal layer portion by way of a die attach film (DAF). The first metal layer at the first major side and the second metal layer at the second major side may be formed from a copper or copper alloy material. The package substrate may be characterized as a metal clad FR4 substrate.

In another embodiment, there is provided, a semiconductor device including a package substrate having a first major side and a second major side; a cavity formed in the package substrate, the cavity having an opening at the first major side; a plurality of metal redistribution traces formed at the first major side, the plurality of redistribution traces substantially surrounding the cavity; a semiconductor die mounted in the cavity; a wire bond having a first end affixed at a bond pad of the semiconductor die and a second end affixed at a wiring pad region of a redistribution trace of the plurality of redistribution traces; an encapsulant encapsulating the semiconductor die and the first major side of the package substrate; a base region of the redistribution trace exposed through the encapsulant; and an under-bump metallization (UBM) structure formed on the exposed base region. The UBM structure may be characterized as a structure formed by way of plating a copper or copper alloy material. The cavity in the package substrate may be formed by way of laser ablation. The package substrate may further include a metal layer formed at the second major side of the package substrate. The cavity formed in the package substrate may expose a portion of the metal layer formed at the second major side of the package substrate. The semiconductor die mounted in the cavity may include a backside of the semiconductor die affixed to the exposed portion of the metal layer by way of a die attach film (DAF).

In yet another embodiment, there is provided, a method including forming a plurality of redistribution traces at a first major side of a package substrate; forming a cavity in the package substrate, the plurality of redistribution traces substantially surrounding an opening of the cavity at the first major side; mounting a semiconductor die in the cavity; forming a wire bond between a bond pad of the semiconductor die and a wiring pad region of a redistribution trace of the plurality of redistribution traces; encapsulating with an encapsulant the semiconductor die and the first major side of the package substrate; and exposing a base region of the redistribution trace. The forming the cavity in the package substrate may include exposing a portion of a second metal layer formed at a second major side of the package substrate. The mounting the semiconductor die in the cavity may include affixing a backside of the semiconductor die on the exposed second metal layer portion by way of a die attach film (DAF). The method may further include selectively plating an under-bump metallization (UBM) structure on the exposed base region of the redistribution trace. The method may further include affixing a conductive package connector on the UBM structure.

By now, it should be appreciated that there has been provided a semiconductor device having an embedded die. The semiconductor device includes a package substrate with a cavity sized sufficiently to embed a semiconductor die within the cavity. The package substrate includes fiberglass reinforced epoxy resin core material such as FR4 with metal layers formed on both top and bottom side of the core. For example, a first metal layer (e.g., copper foil) is formed at a first major side (e.g., top) of the package substrate and a second metal layer (e.g., copper foil) is formed at a second major side (e.g., bottom) of the package substrate such the core is sandwiched between the first metal layer and the second metal layer. A plurality of redistribution traces is formed by patterning and etching the second metal layer, for example. The cavity is formed in central region of the package substrate. The cavity has an opening at the second major side and extends through the core and ends at an inner surface of a portion of the first metal layer at the first major side. The plurality of redistribution traces is arranged to substantially surround the cavity in a fanout configuration, for example. The semiconductor die is mounted in the cavity such that a backside of the semiconductor die is affixed to the exposed inner surface portion of the first metal layer. Bond pads at the active side of the semiconductor die are interconnected with respective redistribution traces by way of bond wires. An encapsulant encapsulates the semiconductor die and the second major side of the package substrate. Openings through the encapsulant are formed exposing base portions of the redistribution traces. Under-bump metallization structures are formed on respective exposed base portions of respective redistribution traces. Conductive package connectors (e.g., solder balls) are affixed to exposed surface portions of respective under-bump metallization structures. By forming the semiconductor device with an embedded semiconductor die in this manner, the semiconductor die is fully protected and capable of high-power applications requiring high current interconnects.

The terms "front," "back," "top," "bottom," "over," "under" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Although the invention is described herein with reference to specific embodiments, various modifications and changes can be made without departing from the scope of the present invention as set forth in the claims below. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

## Claims

1. A method comprising:
patterning a first metal layer at a first major side of a package substrate to form a plurality of redistribution traces;
forming a first cavity in the package substrate, the plurality of redistribution traces substantially surrounding the first cavity;
mounting a semiconductor die in the first cavity;
forming a wire bond between a bond pad of the semiconductor die and a wiring pad region of a redistribution trace of the plurality of redistribution traces;
encapsulating with an encapsulant the semiconductor die and the first major side of the package substrate;
exposing a base region of the redistribution trace; and
selectively plating an under-bump metallization, UBM, structure on the exposed base region.

2. The method of claim 1, wherein exposing the base region of the redistribution trace includes forming a second cavity in the encapsulant by way of laser ablation, the base region of the redistribution trace exposed at the bottom of the second cavity.

3. The method of claim 2, wherein selectively plating the UBM structure includes filling the second cavity with a copper or copper alloy material.

4. The method of any preceding claim, further comprising affixing a conductive package connector on the UBM structure.

5. The method of any preceding claim, wherein forming the first cavity includes exposing a portion of a second metal layer at a second major side of the package substrate.

6. The method of claim 5, wherein forming the first cavity in the package substrate includes using laser ablation to form the first cavity and expose the portion of the second metal layer.

7. The method of claim 5 or 6, wherein mounting the semiconductor die in the first cavity includes affixing a backside of the semiconductor die to the exposed second metal layer portion by way of a die attach film, DAF.

8. The method of any of claims 5 to 7, wherein the first metal layer at the first major side and the second metal layer at the second major side are formed from a copper or copper alloy material.

9. The method of any preceding claim, wherein the package substrate is characterized as a metal clad FR4 substrate.

10. A semiconductor device comprising:
a package substrate having a first major side and a second major side;
a cavity formed in the package substrate, the cavity having an opening at the first major side;
a plurality of metal redistribution traces formed at the first major side, the plurality of redistribution traces substantially surrounding the cavity;
a semiconductor die mounted in the cavity;
a wire bond having a first end affixed at a bond pad of the semiconductor die and a second end affixed at a wiring pad region of a redistribution trace of the plurality of redistribution traces;
an encapsulant encapsulating the semiconductor die and the first major side of the package substrate;
a base region of the redistribution trace exposed through the encapsulant; and
an under-bump metallization, UBM, structure formed on the exposed base region.

11. The device of claim 10, wherein the UBM structure is characterized as a structure formed by way of plating a copper or copper alloy material.

12. The device of claim 10 or 11, wherein the cavity in the package substrate is formed by way of laser ablation.

13. The device of any of claims 10 to 12, wherein the package substrate further comprises a metal layer formed at the second major side of the package substrate.

14. The device of claim 13, wherein the cavity formed in the package substrate exposes a portion of the metal layer formed at the second major side of the package substrate.

15. The device of claim 14, wherein the semiconductor die mounted in the cavity includes a backside of the semiconductor die affixed to the exposed portion of the metal layer by way of a die attach film, DAF.
